# FASCICULE DE BREVET EUROPEEN

(11) **EP 0 800 248 B1**
(45) Date de publication et mention de la délivrance du brevet: **06.02.2002**
(21) Numéro de dépôt: 97400696.7
(22) Date de dépôt: 27.03.1997
(51) Int. Cl.: H02B 15/00, H05K 7/14

(54) **Dispositif de commande d'appareillage haute tension comportant un agencement synoptique**
Hochspannungsgerätesteuervorrichtung mit einer Übersichtsanzeigeanordnung
Control device for high voltage apparatus containing synoptic means

(30) Priorité: 03.04.1996 FR 9604191
(43) Date de publication de la demande: 08.10.1997
(73) Titulaire: GEC ALSTHOM T & D SA, 75116 Paris (FR)
(72) Inventeur: Marmonier, Jean, 73100 Aix Les Bains (FR)
(74) Mandataire: Gosse, Michel

(56) Documents cités:
- DE-U- 8 519 474
- US-A- 3 582 927

## Description

La présente invention se rapporte à un dispositif de commande d'appareillage haute tension comportant un agencement synoptique.

Elle concerne plus précisément un dispositif de commande d'un appareillage haute tension comprenant
- un calculateur destiné à recevoir des informations d'états en provenance de l'appareillage par l'intermédiaire d'au moins un cordon de transmission,
- un agencement synoptique comportant un dispositif support portant sur sa face visible un descriptif de schéma synoptique de signalisation d'états de l'appareillage associé à des lampes de signalisation.

La commande d'appareillages haute tension peut être de façon classique effectuée selon trois modes d'exploitation:
- à partir d'une salle de commande centralisée où sont transmis les ordres de commande au calculateur;
- à partir d'une armoire locale, en mode d'exploitation dit local, où peuvent être actionnés des boutons de commande de l'agencement synoptique, le calculateur étant opérationnel, le calculateur et l'agencement synoptique étant logés dans cette armoire;
- à partir de l'armoire locale, en mode d'exploitation dit d'urgence, où le calculateur n'est pas opérationnel.

Un commutateur à trois positions permet typiquement de choisir le mode d'exploitation.

Le calculateur de technologie numérique permet d'assurer les automatismes, par exemple les verrouillages en fonction des positions des autres appareils haute tension, de l'état de densité du gaz diélectrique des différents compartiments dans le cas d'appareillages sous enveloppe métallique ou autre, etc...

Ce calculateur remplace les dispositifs à relais électromécaniques utilisés auparavant et permet une possibilité d'évolution vers des fonctions plus évoluées, par exemple une surveillance d'état de l'appareillage et une possibilité de communication avec un niveau de contrôle et de commande supérieur par l'intermédiaire d'un bus de communication.

Cependant cette technologie se heurte à une réticence des exploitants du fait de la nécessité d'une remise en question des méthodes de maintenance et surtout de la crainte d'une défaillance majeure du calculateur qui rendrait le système totalement inopérant et l'exploitation impossible.

Par ailleurs, la fonction synoptique est actuellement effectuée par deux types d'agencement:
- par un agencement synoptique totalement indépendant du calculateur, c'est-à-dire dont les boutons de commande et les lampes de signalisation sont physiquement séparés du calculateur; cet agencement synoptique est alors alimenté par une polarité indépendante de celle du calculateur et par un cordon de transmission d'informations d'états en provenance de l'appareillage également indépendant de celui du calculateur; l'exploitation en mode urgence peut donc être réalisée sans problème à partir de l'agencement synoptique indépendant et cette solution s'avère donc fiable mais coûteuse.
- par un agencement synoptique totalement intégré au calculateur, c'est-à-dire dont les boutons de commande et les lampes de signalisation sont physiquement intégrés au calculateur; il est alors directement alimenté par le calculateur mais en cas de défaillance de ce dernier, cet agencement synoptique n'est plus opérationnel; cette solution s'avère donc relativement économique mais non fiable pour l'exploitant puisqu'en cas de défaillance du calculateur, l'exploitation en mode urgence n'est pas possible.

Les documents US-A- 3582927 et DE-U- 85 19 474 décrivent un dispositif de commande du genre mentionné ci-dessus.

Le dispositif de commande conforme à l'invention résout ces problèmes, en étant moins coûteux que les dispositifs de commande comportant le premier type d'agencement synoptique tout en étant plus fiable que ceux comportant le second type d'agencement synoptique. Il présente un rapport fiabilité/coût optimal.

Pour ce faire, conformément à l'invention, ledit agencement synoptique comporte également au moins un connecteur directement relié audit cordon de transmission, comportant lesdites lampes de signalisation et connecté de façon amovible audit calculateur sur une face de celui-ci dite face de connexion, ledit dispositif support et ledit connecteur étant disposés de telle sorte que ce dernier présente lesdites lampes de signalisation de façon associée audit descriptif du dispositif support, qu'il soit connecté avec le calculateur en position dite normale ou déconnecté du calculateur en position dite d'urgence.

Selon le mode de réalisation préféré de l'invention, le dispositif support est parallèle à la face de connexion du calculateur et fixée sur celui-ci.

Avantageusement, le dispositif support comporte des moyens de maintien du connecteur en position d'urgence.

De préférence, le dispositif support est une plaque pivotante sur le calculateur et l'association des lampes de signalisation du connecteur et du descriptif porté par ladite plaque est réalisé par logement du connecteur dans des orifices réalisés dans la plaque.

De façon connue en soi, le dispositif support porte également des boutons de commande locale.

L'invention est décrite ci-après plus en détail à l'aide de figures ne représentant qu'un mode de réalisation préféré de l'invention.

Les figures 1 à 4 représentent des vues en perspective d'un dispositif de commande conforme à l'invention.

La figure 5 est une vue en coupe partielle de détail.

Le dispositif de commande d'un appareillage haute tension comprend
- un calculateur 1 numérique destiné à recevoir des informations d'états en provenance de l'appareillage et à transmettre des ordres de commande programmés en provenance d'un niveau supérieur,
- un agencement synoptique comportant un dispositif support constitué d'une plaque 2 portant sur sa face visible un descriptif 3 de schéma synoptique de signalisation d'états de l'appareillage et des boutons de commande locale 5,
- des connecteurs 6 directement reliés à un cordon de transmission 7 des informations d'états en provenance de l'appareillage, comportant des lampes de signalisation 4 destinées à être associées au descriptif 3 et connectés de façon amovible au calculateur 1 sur une face 1A de celui-ci dite face de connexion. De tels connecteurs 6 sont en soi connus et utilisés dans les installations d'automates programmables.

La plaque 2 et les connecteurs 6 sont disposés de telle sorte que ces derniers présentent les lampes de signalisation 4 de façon associée au descriptif 3 de la plaque 2, qu'ils soient connectés avec le calculateur 1 en position dite normale ou déconnectés du calculateur 1 en position dite d'urgence.

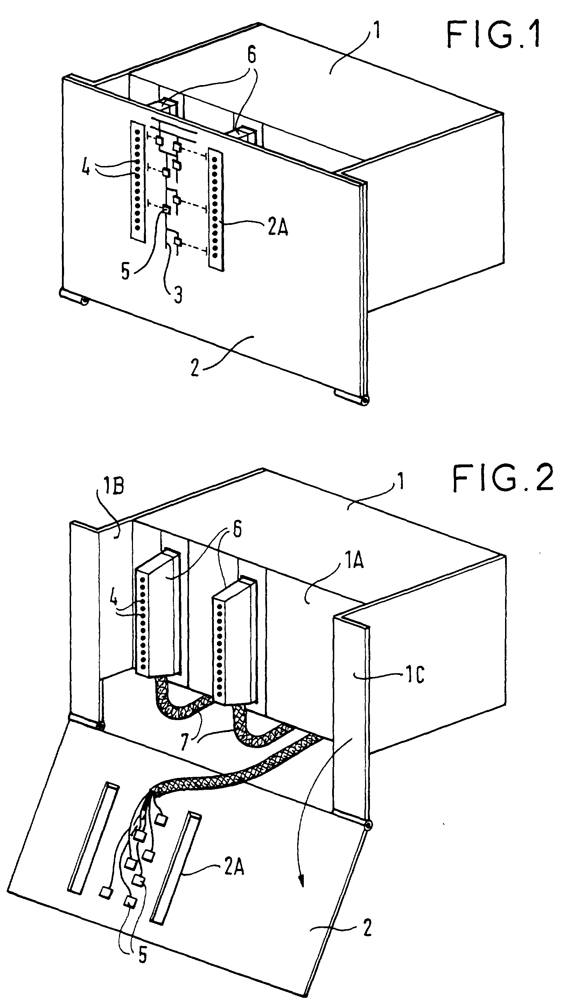

Les figures 1 à 4 illustrent ces deux positions.

Sur la figure 1, le dispositif est en position normale.

Les connecteurs 6 sont embrochés sur le calculateur 1. Ils reçoivent les informations d'états de l'appareillage par leur cordon de transmission 7 et les transmettent au calculateur 1. La plaque 2 est maintenue parallèlement sur la face de connexion 1A par liaison mécanique, précisée plus loin, à deux parois latérales 1B, 1C prolongeant le boîtier du calculateur 1 sur la face de connexion 1A. L'association des lampes de signalisation 4 des connecteurs 6 et du descriptif 3 porté par la plaque 2 est réalisé par logement de la face avant des connecteurs 6 portant les lampes 4 dans des orifices 2A réalisés dans la plaque 2.

Le dispositif de commande peut donc fonctionner en mode d'exploitation local, par l'intermédiaire des boutons de commande 5, le calculateur 1 étant opérationnel.

En cas d'opération de mise hors service du calculateur 1, en général pour permettre une intervention sur celui-ci par exemple défaillant, dans un premier temps, la plaque 2 est éloignée de la face 1A de connexion du calculateur 1, comme représenté sur la figure 2. Pour ce faire, elle est avantageusement pivotante sur le bord horizontal inférieur des parois latérales 1B, 1C au moyen de charnières. Les boutons de commande 5 sont déplacés avec la plaque 2.

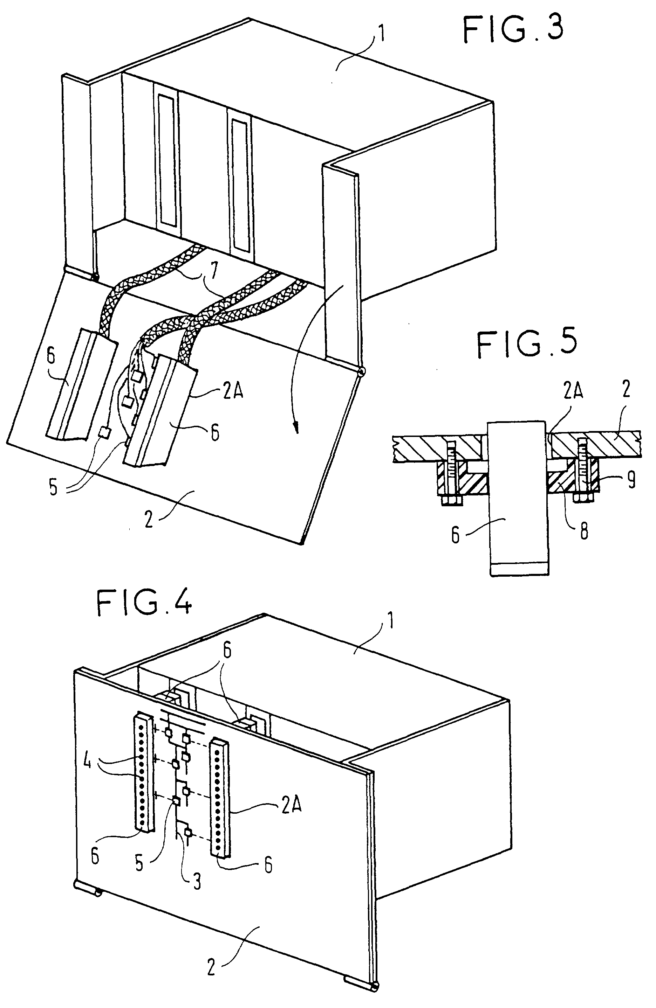

Dans un second temps, les connecteurs 6 sont déconnectés du calculateur 1 et fixés sur la plaque 2 comme représenté sur la figure 3. Pour ce faire, la plaque 2 comporte des moyens de maintien des connecteurs dont un mode de réalisation préféré sera décrit plus loin.

Le calculateur 1 est alors hors fonction et il est possible de procéder à une intervention telle que l'enlèvement d'une carte défectueuse pour réparation.

Dans un troisième temps, la plaque 2 est remise en place contre les parois latérales 1B, 1C par pivotement et fixation mécanique contre celles-ci, par exemple par l'intermédiaire de crochets ou d'attaches aimantées, comme représenté sur la figure 4. Du fait des moyens de maintien, les connecteurs 6 sont légèrement éloignés de la face de connexion 1A.

Le dispositif est alors en position d'urgence, une surveillance de l'appareillage pouvant être réalisée par l'intermédiaire des lampes de signalisation 4 associées au descriptif 3 et une commande locale pouvant être effectuée par l'intermédiaire des boutons de commande 5, le calculateur étant inopérant.

Un mode de réalisation des moyens de maintien des connecteurs 6 sur la plaque 2 en position d'urgence est représenté sur la figure 5.

Sur au moins deux bords des orifices 2A dont un seul est ici représenté, des pièces 8 en matériau élastique, par exemple en caoutchouc, sont fixées à la plaque 2 par vissage ou rivetage 9. Ces pièces 8 sont espacées de telle sorte qu'une fois le connecteur 6 introduit entre elles et dans l'orifice 2A, elles exercent un effort de compression sur les parois du connecteur 6 assurant son maintien.

Cet effort de compression est par contre insuffisant pour retenir le connecteur 6 lorsqu'il est embroché sur la face de connexion 1A du calculateur 1, comme représenté sur la figure 2.

## Revendications

1. Dispositif de commande d'un appareillage haute tension comprenant
- un calculateur (1) destiné à recevoir des informations d'états en provenance de l'appareillage par l'intermédiaire d'au moins un cordon de transmission (7),
- un agencement synoptique comportant un dispositif support (2) portant sur sa face visible un descriptif (3) de schéma synoptique de signalisation d'états de l'appareillage associé à des lampes de signalisation (4),
**caractérisé en ce que** ledit agencement synoptique comporte également au moins un connecteur (6) directement relié audit cordon de transmission (7), comportant lesdites lampes de signalisation (4) et connecté de façon amovible audit calculateur (1) sur une face (1A) de celui-ci dite face de connexion, ledit dispositif support (2) et ledit connecteur (6) étant disposés de telle sorte que ce dernier présente lesdites lampes de signalisation (4) de façon associée audit descriptif (4) du dispositif support (2), qu'il soit connecté avec le calculateur (1) en position dite normale ou déconnecté du calculateur (1) en position dite d'urgence.

2. Dispositif selon la revendication 1, **caractérisé en ce que** le dispositif support (2) est parallèle à la face de connexion (1A) du calculateur (1) et fixée sur celui-ci.

3. Dispositif selon l'une des revendications précédentes, **caractérisé en ce que** le dispositif support (2) comporte des moyens de maintien (8) du connecteur (6) en position d'urgence.

4. Dispositif selon l'une des revendications précédentes, **caractérisé en ce que** le dispositif support (2) est une plaque pivotante sur le calculateur (1).

5. Dispositif selon la revendication 4, **caractérisé en ce que** l'association des lampes de signalisation (4) du connecteur (6) et du descriptif (3) porté par ladite plaque (2) est réalisé par logement du connecteur (6) dans des orifices (2A) réalisés dans la plaque (2).

6. Dispositif selon l'une des revendications précédentes, **caractérisé en ce que** le dispositif support (2) porte également des boutons de commande locale (5).

## Claims

1. A control device for high-voltage equipment including
- a computer (1) adapted to receive status information from the equipment via at least one transmission cable (7), and
- a display system including a support device (2) carrying on its visible face an equipment status mimic diagram (3) associated with indicator lamps (4)
**characterized in that** said display system also includes at least one connector (6) connected directly to said transmission cable (7), incorporating said indicator lamps (4) and removably connected to said computer (1) at a connection face (1A) thereof, said support device (2) and said connector (6) being so disposed that the latter presents said indicator lamps (4) in a manner associated with said mimic diagram (4) of the support device (2) whether it is connected to the computer (1) in a normal position or disconnected from the computer (1) in an emergency position.

2. The device according to claim 1 **characterized in that** the support device (2) is parallel to the connection face (1A) of the computer (1) and fixed to the latter.

3. The device according to any of the above claims, **characterized in that** the support device (2) includes means (8) for holding the connector (6) in the emergency position.

4. The device according to any of the above claims, **characterized in that** the support device (2) is a plate pivoting on the computer (1).

5. The device according to claim 4 **characterized in that** the indicator lamps (4) of the connector (6) and the mimic diagram (3) carried by said plate (2) are associated by lodging the connector (6) in orifices (2A) in the plate (2).

6. The device according to any of the above claims, **characterized in that** the support device (2) also carries local control buttons (5).

## Patentansprüche

1. Steuervorrichtung für Hochspannungsgeräte, welche umfasst
- einen Rechner (1), der von den Geräten stammende Zustandsinformationen mittels wenigstens eines Übertragungskabels (7) empfangen soll,
- eine Übersichtsanzeigeanordnung mit einer Stützvorrichtung (2), die auf ihrer sichtbaren Seite eine mit Signallampen 4 verbundene Beschreibung (3) des Übersichtsschemas der Signale der Zustände der Geräte aufweist,
**dadurch gekennzeichnet, dass** die Übersichtsanzeigeanordnung gleichermaßen wenigstens einen direkt mit dem Übertragungskabel (7) verbundenen Stecker (6) mit den Signallampen (4) aufweist, der in lösbarer Weise mit dem Rechner (1) auf dessen sogenannter Anschlussseite (1A) mit diesem verbunden ist, wobei die Stützvorrichtung (2) und der Stecker (6) derart angeordnet sind, dass der letztgenannte die zur Beschreibung (3) der Stützvorrichtung (2) gehörenden Signallampen (4) aufweist, und in einer sogenannten Normalposition mit dem Rechner (1) verbunden oder in einer sogenannten Notfallposition vom Rechner (1) getrennt ist.

2. Vorrichtung nach Anspruch 1,
**dadurch gekennzeichnet, dass** die Stützvorrichtung (2) parallel zur Anschlussseite (1A) des Rechners (1) liegt und auf dieser befestigt ist.

3. Vorrichtung nach einem der vorhergehenden Ansprüche,
**dadurch gekennzeichnet, dass** die Stützvorrichtung (2) Mittel zur Befestigung (8) des Steckers (6) in der Notfallposition aufweist.

4. Vorrichtung nach einem der vorhergehenden Ansprüche,
**dadurch gekennzeichnet, dass** die Stützvorrichtung (2) eine auf dem Rechner (1) drehbare Platte ist.

5. Vorrichtung nach Anspruch 4,
**dadurch gekennzeichnet, dass** die Verbindung der Signallampen (4) des Steckers (6) und der von der Platte (2) getragenen Beschreibung (3) durch Anordnen des Steckers (6) in in der Platte (2) ausgeführten Öffnungen (2A) erfolgt.

6. Vorrichtung nach einem der vorhergehenden Ansprüche,
**dadurch gekennzeichnet, dass** die Stützvorrichtung (2) gleichermaßen Knöpfe zur lokalen Steuerung (5) trägt.
